# EUROPÄISCHE PATENTSCHRIFT

(11) **EP 0 606 294 B1**
(45) Veröffentlichungstag und Bekanntmachung des Hinweises auf die Patenterteilung: **28.01.1998**
(21) Anmeldenummer: 92920243.0
(22) Anmeldetag: 30.09.1992
(51) Int. Cl.: H05K 3/00, H05K 9/00

(54) **GERÄTEAUFBAU EINES ELEKTROTECHNISCHEN GERÄTES**
STRUCTURE OF AN ELECTROTECHNICAL DEVICE
CONSTRUCTION D'UN APPAREIL ELECTROTECHNIQUE

(30) Priorität: 04.10.1991 DE 4132994
(43) Veröffentlichungstag der Anmeldung: 20.07.1994
(73) Patentinhaber: Bodenseewerk Gerätetechnik GmbH, 88662 Überlingen (DE)
(72) Erfinder: NEUMANN, Werner, D-7776 Owingen (DE)
(74) Vertreter: Weisse, Jürgen, Dipl.-Phys. Patentanwalt
(86) Internationale Anmeldenummer: EP9202266
(87) Internationale Veröffentlichungsnummer: WO9307737

(56) Entgegenhaltungen:
- EP-A- 0 403 975
- CH-A- 607 543
- DE-A- 3 211 758
- DE-A- 3 417 451
- DE-A- 3 500 411
- US-A- 4 758 459
- US-A- 4 758 459

## Beschreibung

### Technisches Gebiet

Die Erfindung betrifft den Geräteaufbau eines elektrotechnischen Gerätes mit plattenförmigen Gehäusewänden aus Kunststoff,
(a) die einseitig flächig metallisiert sind und
(b) die als Leiterplatten derart ausgebildet sind, daß sie auf der nicht flächig metallisierten Seite mit elektrischen und/oder mechanischen Bauteilen bestückt und mit Leiterbahnen versehen sind, die zur elektrischen Verbindung und/oder Anschluß von Bauteilen dienen

### Zugrundeliegender Stand der Technik

Geräteaufbauten für elektrotechnische Geräte sind in zahlreichen Formen bekannt. Unter elektrotechnischen Geräten werden im folgenden Geräte verstanden, die aus mechanischen, elektromechanischen, elektrischen und/oder elektronischen Bauteilen zusammengesetzt sind. Die Gehäuse dienen unter anderem dem Schutz der in ihnen angeordneten Bauteile gegen äußere Einflüsse. Bei den äußeren Einflüssen kann es sich um mechanische Einwirkungen handeln sowie auch um Witterungseinflüsse oder ähnliche äußere Einwirkungen. Falls das Gehäuse aus Metall besteht, kann es die in ihm angeordneten Bauteile auch gegen Einflüsse von elektrischen oder elektromagnetischen Feldern schützen (EMV-Schutz, Blitzschutz u.ä.). An den Gehäusewänden oder an innerhalb des Gehäuses angeordneten Platten oder Wänden können Bauteile angeordnet sein, die zur Aufnahme und Führung von Leiterplatten oder Leiterkarten dienen, auf denen mechanische, elektrische, elektromechanische oder elektronische Bauteile angeordnet sind. In den Gehäusen können Leiterplatten oder Leiterkarten angeordnet sein, die mit Kartensteckern versehen sind und zur Verbindung der einzelnen Leiterplatten oder Leiterkarten untereinander liegen. Die einzelnen Bauteile können auf den Leiterplatten oder Leiterkarten mit Hilfe der SMD-Technik angeordnet sein. In den Gehäuseaußenwänden können sich Durchbrüche befinden, die zur Aufnahme von Gerätesteckern und/oder Teststeckern dienen. Die Gehäusewände können aus miteinander verbundenen plattenförmigen Bauteilen bestehen. Hierdurch lassen sich Größe und Form des Gehäuses leicht an die jeweiligen Erfordernisse anpassen und die Fertigungskosten werden bei kleinen und mittleren Stückzahlen erheblich vermindert. Durch die Verwendung von biegsamen Verbindungen in SMD-Technik entfällt die Notwendigkeit, zur Verbindung einzelner Baugruppen Kabelbäume zu verwenden, die in der Herstellung aufwendig sind, deren Verlegung Durchbrüche und Halterungen erfordert und bei denen Verbindungsfehler nicht immer vermeidbar sind. Es ist ohne Mühe und aufwendige Vorbereitungen möglich, einzelne oder mehrere Baugruppen zu prüfen, ohne daß ein Gesamtaufbau des Gerätes erforderlich wäre. Dies hat eine Verminderung der zum Aufbau des Gerätes erforderlichen Arbeitszeit und der Einzelteilzahl zur Folge sowie eine Verminderung des zeitaufwandes für die Prüfung. Trotzdem bleiben die einzelnen Bauteile und Baugruppen leicht zugänglich.

Aus der DE-OS 34 17 451 ist ein quaderförmiges Einschubgehäuse für elektronische Geräte bekannt, in das Steckkarten-Moduleinschübe und dergleichen eingeschoben werden können, dessen Deckplatte, Bodenplatte, Seitenplatten und Schienen aus einem einstückigen Kunststoff-Spritzteil besteht, wobei das Gehäuse an der Innen- und/oder Außenseite mit einer elektrischleitenden oder ferromagnetischen Schicht versehen ist. Diese Beschichtung ist bevorzugt allseitig umlaufend vorgesehen. Bei diesem Gehäuse ist es jedoch nicht vorgesehen, die Gehäusewände selbst als Leiterplatten auszubilden.

Aus der US-A-4 758 459 ist eine Leiterplatine bekannt, die derart geformt ist, daß sie als einteiliges Gehäuse ausgebildet ist. Die Außenflächen können gegebenenfalls metallisiert werden. Innerhalb des Gehäuses sind Leiterplatten angeordnet, die mechanisch mit den Gehäusewänden verbunden sein können. Die Verbindung der Leiterplatten miteinander und deren Ableitungen erfolgen durch eine zentral im Gehäuse angeordnete Verdrahtung.

Die Bestückung von Leiterplatten mit Hilfe der SMD-Technik unter Verwendung von Klebeverbindungen ist aus Miszak Jerzy "Der Einsatz von Klebstoffen in Mikroelektronik, Mikrotechnik und Telekommunikation", Technische Rundschau, 20/86, S. 50-53, bekannt und die Verbindung eines Flexbandes mit einer Leiterplatte aus der DE-OS 35 00 411.

Weiterhin ist aus der DE-OS 39 28 461 ein Baugruppenträger mit zwei metallischen Seitenwänden bekannt, zwischen denen an den vier Ecken jeweils Profilschienen aus Metall verlaufen, die an den Seitenwänden befestigt sind und Führungshalter tragen, die für die Aufnahme von Baugruppen bestimmt sind.

Aus der DE-PS 32 11 758 ist ein Gehäuse für die elektrische Nachrichtentechnik bekannt, das einen Blechrahmen des Gehäuses aufweist und dessen einzelne gegenseitig geschirmte Einschübe aus wannenförmigen Blechteilen bestehen.

### Offenbarung der Erfindung

Der Erfindung liegt die Aufgabe zugrunde, einen Geräteaufbau eines elektrotechnischen Gerätes zu schaffen, dessen Gehäusewände aus plattenförmigen Bauteilen bestehen und dessen Abmessungen und Gewicht gegenüber den bekannten Bauformen erheblich verringert werden. Diese Verringerung ist in nahezu allen Anwendungsfällen, besonders aber bei der Luft- und Raumfahrt, in hohem Maße wünschenswert und von großem Vorteil. Der Geräteaufbau soll ohne großen Arbeitsaufwand und mit geringen Kosten durchgeführt werden.

Bei dem Geräteaufbau gemäß der Erfindung muß trotz der Verringerung von Abmessungen und Gewicht nicht inkauf genommen werden, daß andere wichtige Eigenschaften beeinträchtigt werden, wobei es sich insbesondere um den Schutz des Gerätes gegen mechanische Einflüsse wie Schock und Vibration, Einflüsse von Temperatur, Feuchtigkeit und ähnlichem und auch den Schutz vor elektrischen und elektromagnetischen Feldern (EMV-Schutz, Blitzschutz u.ä.) handelt.

Erfindungsgemäß wird diese Aufgabe durch einen Geräteaufbau gemäß Oberbegriff gelöst bei dem
(c) die Gehäusewände aus miteinander mechanisch verbundenen plattenförmigen Bauteilen bestehen
(d) die metallisierten Flächen der Gehausewände untereinander elektrisch verbunden sind und
(e) etwa vorhandene aus Metall bestehende weitere plattenförmige Bauteile (4,5,6) mit den metallisierten Flächen der Kunststoffplatten (1,2,3) elektrisch leitend verbunden sind.

Ausgestaltungen der Erfindung sind Gegenstand der Unteransprüche.

Ein Ausführungsbeispiel der Erfindung ist nachstehend unter Bezugnahme auf die zugehörigen Zeichnungen näher erläutert.

### Kurze Beschreibung der Zeichnungen

- Fig. 1: zeigt eine Aufsicht auf den Geräteaufbau bei abgenommenem Deckel.
- Fig. 2: zeigt einen Schnitt durch den Geräteaufbau nach der Linie II II der Fig. 1.
- Fig. 3: ist eine perspektivische geöffnete Ansicht des Geräteaufbaues nach den Fig. 1 und 2.
- Fig. 4: zeigt den Geräteaufbau gemäß Fig. 3 nach Entfernung weiterer Leiterplatten und der Stirn- sowie Rückwand.
- Fig. 5: zeigt einen Teil einer Seitenwand mit daran angeordnetem Befestigungswinkel.
- Fig. 6: zeigt die elektrisch leitende Verbindung einer Seitenwand mit einem Befestigungswinkel.
- Fig. 7: zeigt die Anordnung eines Kartensteckers auf einer Bodenplatte.
- Fig. 8: zeigt in vereinfachter perspektivischer Aufsicht die Verbindung einer starren Leiterplatte mit auf einem flexiblen Träger angeordneten Leiterbahnen und
- Fig. 9: zeigt als Einzelheit aus Fig. 8 Teilabschnitte einer starren Leiterplatte und eines flexiblen Teiles vor dem Herstellen der Verbindung.

### Bevorzugte Ausführung der Erfindung

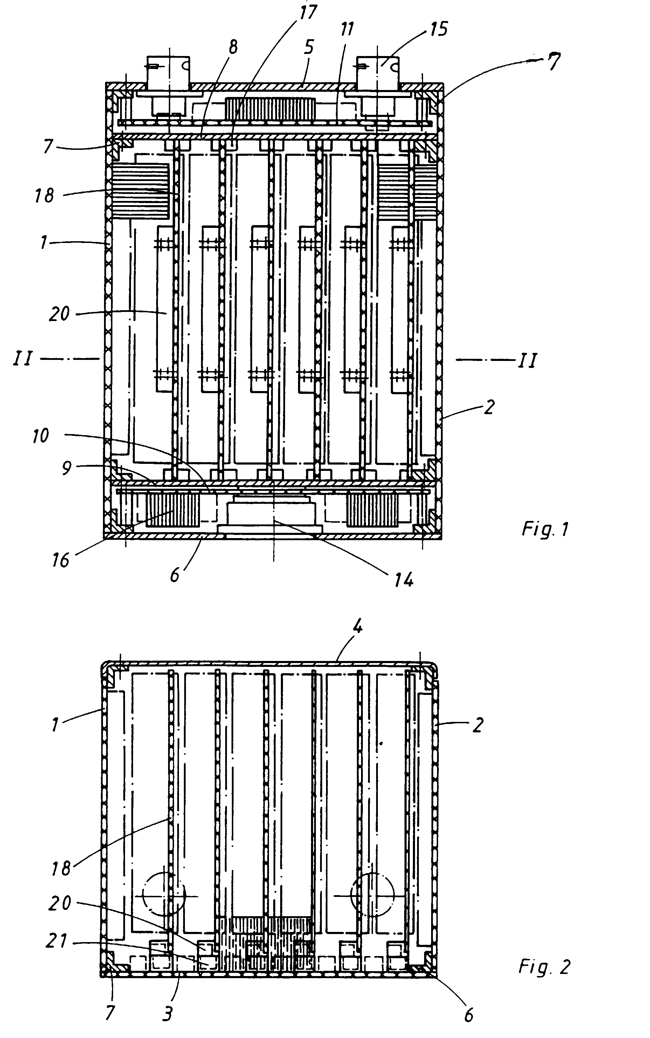

In den Fig. 1 und 2 sind die Seitenwände mit 1 und 2 und in Fig. 2 der Boden mit 3 bezeichnet. Seitenwände und Boden bestehen aus glasfaserverstärktem oder kohlefaserverstärktem Kunststoff und sind auf ihren Außenseiten ganzflächig metallisiert oder mit einer Metallschicht, insbesondere aus Kupfer, kaschiert. Die Metallisierung erstreckt sich auch auf die Schnittkanten dieser plattenförmigen Bauteile 1, 2 und 3. Hierdurch sind die außenseitigen Metallisierungen der plattenförmigen Bauteile 1, 2 und 3 leitend miteinander verbunden, obwohl auch weitere in der Zeichnung nicht dargestellte leitende Verbindungen vorhanden sein können. Der in Fig. 2 mit 4 bezeichnete Deckel besteht aus Aluminium, ebenso wie die in Fig. 1 erkennbare Stirnwand 5 und die Rückwand 6. Die Wände 5 und 6 sind mit den metallisierten Flächen der Seitenwände 1 und 2 und des Bodens 3 leitend verbunden. Zur mechanischen Verbindung dienen Befestigungswinkel 7 die aus stranggepreßtem Aluminium bestehen können.

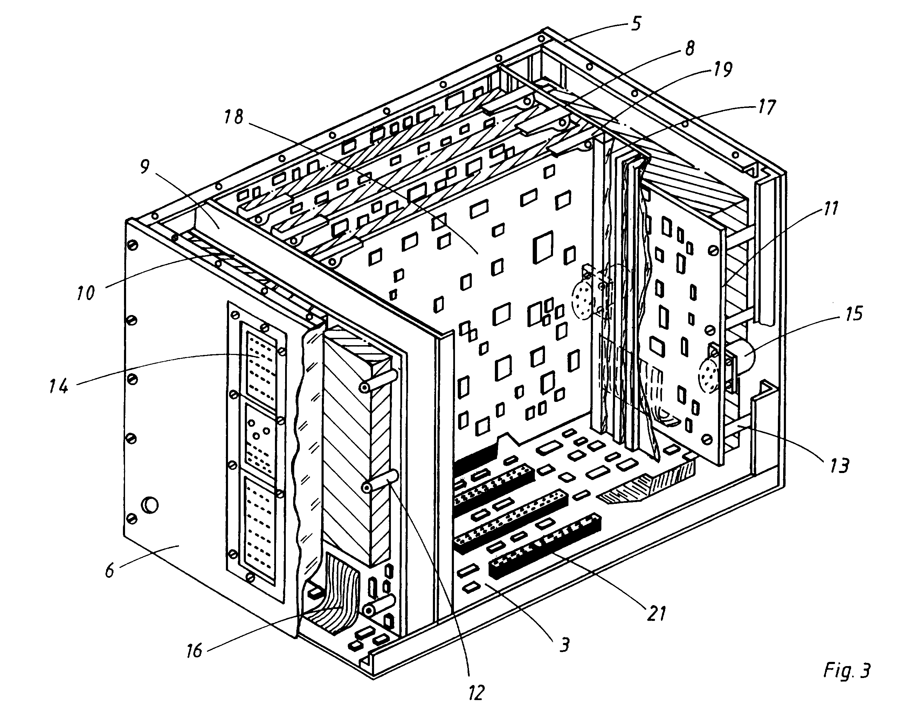

Wie aus den Fig. 1 und 3 zu erkennen ist, erstrecken sich zwischen den Seitenwänden 1 und 2, parallel zur Stirnwand 5 bzw. zur Rückwand 6 und in einem Abstand von diesen verlaufend Schottwände 8 und 9. Diese Schottwände 8 und 9 bestehen aus Aluminium. In der Höhe erstrecken sie sich vom Boden 3 bis zum Deckel 4. In dem Raum zwischen der Rückwand 6 und der Schottwand 9 befindet sich eine Leiterplatte 10 und in gleicher Weise zwischen der Stirnwand 5 und der Schottwand 8 eine Leiterplatte 11. Die Leiterplatten 10 und 11 sind mit der Stirnwand 5 bzw. der Rückwand 6 durch Abstandhalter 12 bzw. 13 mechanisch verbunden. Die Räume in denen sich die Leiterplatten 10 und 11 befinden sind, insbesondere wenn sich in der Stirnwand 5 und/oder der Rückwand 6 Durchbrüche für Gerätestecker 14 bzw. Teststecker 15 befinden, gegen den Einfluß von magnetischen oder elektromagnetischen Feldern nicht so vollkommen geschützt wie der Raum zwischen den Schottwänden 8 und 9. Auf den Leiterplatten 10 und 11 können Bauteile angeordnet sein, die in dieser Hinsicht nicht größtmöglichen Schutz benötigen wie etwa Filterbaugruppen, Blitzschutzanordnungen oder ähnliches. Die Leiterplatten 10 und 11 können auch mit den Gerätesteckern 14 bzw. Teststeckern 15 bestückt sein. Ansonsten kann die Bestückung der Leiterplatten 10 und 11 auch beidseitig erfolgen. Die elektrische Verbindung der Leiterplatten 10 und 11 mit der Bodenplatte 3 erfolgt durch flexible Verbindungsstreifen 16. Hierbei handelt es sich um Streifen bzw. Bänder aus einem flexiblen nichtleitenden Folienmaterial, auf denen sich eine Mehrzahl von Leiterbahnen befindet. Diese flexiblen Verbindungsstreifen 16 und die Verbindungen ihrer Leiterbahnen mit den Leiterbahnen derjenigen Leiterplatten an denen sie angeordnet sind, wird weiter unten näher beschrieben.

Auf den Innenseiten der Schottwände 8 und 9 befinden sich Führungen 17 für Leiterplatten 18. Die Führungen 17 und die zugehörigen Arretierungen 19 sind in den Zeichnungen nur schematisch dargestellt. Die Leiterplatten 18 sind zumindest zum Teil beidseitig bestückt. Bei der Wahl der Bestückungstechnik besteht eine große Freiheit, die Verbindung kann mit Hilfe der Drahtenden der Bauelemente erfolgen oder die Bauelemente können mit Hilfe der SMD-Technik auf den Leiterplatten angeordnet sein, die Leiterplatten können mit Bohrungen versehen und/oder durchkontaktiert sein oder aber, insbesondere bei Anwendung der SMD-Technik, Bohrungen oder Durchkontaktierungen nicht aufweisen.

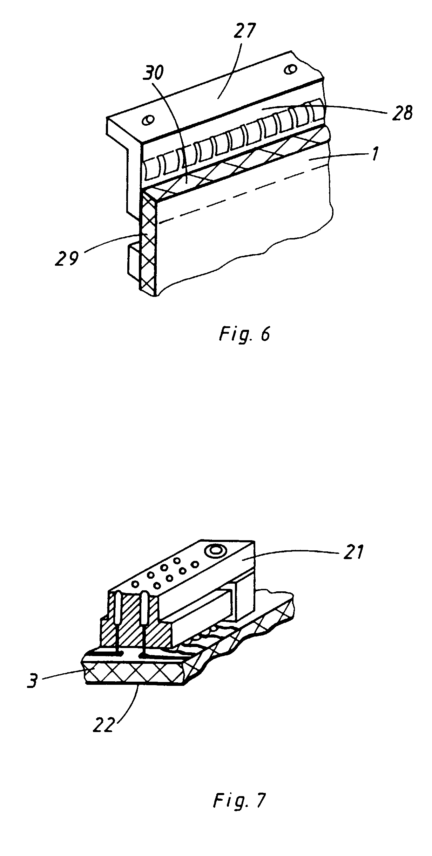

Die Verbindung der Leiterplatten 18 mit der Bodenplatte 3 erfolgt über Kartenstecker 20, 21. Deren Teile 20 sind an den Leiterplatten 18 befestigt, während deren Teile 21 auf dem Boden 3 angeordnet sind. Wie aus Fig. 7 erkennbar ist, erfolgt die Anordnung der Steckerteile 21 auf dem Boden 3 in der Weise, daß eine, elektrische Verbindung der im Steckerteil 21 befindlichen elektrisch leitenden Teile wohl mit auf der Oberseite der Bodenplatte 3 angeordneten Leiterbahnen besteht, nicht aber mit der auf der Unterseite der Bodenplatte 3 befindlichen Metallisierung 22.

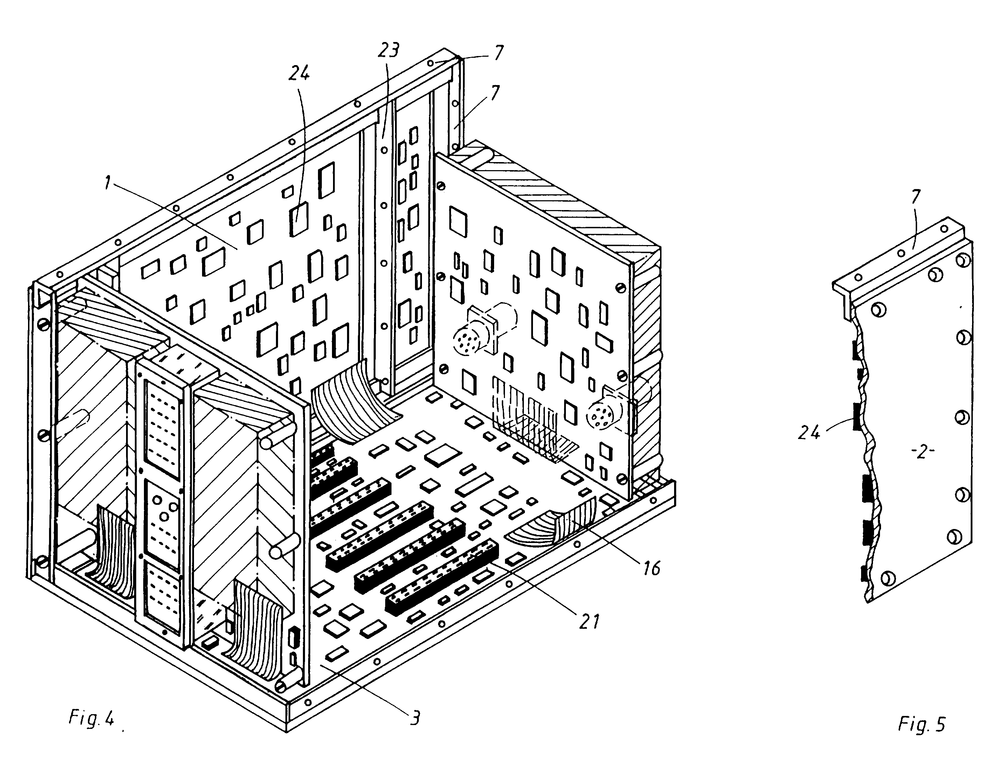

Fig. 4 zeigt in gleicher Darstellung wie Fig. 3 einen gleichen Geräteaufbau, bei dem jedoch die Leiterplatten 18 und die Schottwände 8 und 9 fortgelassen sind. Der zur Befestigung der Schottwand 8 dienende Befestigungswinkel ist mit 23 bezeichnet. Die in den Fig. 3 und 4 nicht erkennbare Außenseite der Seitenwand 1 ist ganzflächig metallisiert. Wie insbesondere aus Fig. 4 zu erkennen ist, ist die dem Geräteinneren zugewandte Seite der Seitenwand 1 als Leiterplatte ausgebildet und hierzu mit Leiterbahnen versehen und in SMD-Technik mit Bauteilen 24 bestückt. In entsprechender Weise ist, wie aus Fig. 5 erkennbar ist, die Seitenwand 2 ausgebildet. Bei dieser Ausbildung der Seitenwände 1 und 2 sind deren zum Geräteinneren weisenden Leiterplattenseiten und deren nach außen weisenden durchgehenden metallisierte Oberflächen elektrisch voneinander unabhängig. Die elektrische Verbindung der Leiterplattenseiten der Seitenwände 1 und 2 mit der Bodenplatte 3 erfolgt durch flexible Verbindungsstreifen 16.

Durch die obenbeschriebene jeweils einseitige Ausbildung der Seitenwände 1 und 2 als Leiterplatten wird eine erhebliche Verminderung des Volumens und des Gewichtes des Geräteaufbaues erzielt. Die Gewichtsverminderung entspricht dem Gewicht von zwei (einseitig bestückten) Leiterplatten oder einer (zweiseitig bestückten) Leiterplatte und entsprechend vermindert sich der Raumbedarf. Eine weitere Gewichtsverminderung wird dadurch erzielt, daß für die Seitenwände 1 und 2 nicht Aluminium verwendet wird, sondern ein spezifisch wesentlich leichterer glasfaser- oder kohlefaserverstärkter Kunststoff, dessen mechanische Eigenschaften dem Aluminium zumindest ebenbürtig sind. Entsprechendes trifft auch für den aus metallisiertem Kunststoff bestehenden Boden 3 zu.

Es ist dafür Sorge getragen, daß die metallisierten oder metallkaschierten Außenflächen der Seitenwände 1 und 2 sowie des Bodens 3 in sicherer elektrisch leitender Verbindung mit den aus Metall bestehenden Strukturteilen des Geräteaufbaues stehen, wie etwa dem Deckel 4, der Stirnwand 5, der Rückwand 6, den Schottwänden 8 und 9 sowie den Befestigungswinkeln 7 und 23 stehen.

Ein Beispiel einer unmittelbaren elektrisch leitenden Verbindung ist anhand von Fig. 6 dargestellt. Dort ist ein Abschnitt eines der in Fig. 4 erkennbaren Befestigungswinkel 7 mit 27 bezeichnet. Auf demjenigen Schenkel gegen den die Seitenwand 1 (oder 2) zur Anlage kommen soll ist unter elektrisch leitender Verbindung ein Massefederband 28 angeordnet. Die Seitenwand 1 ist auf ihrer in der Zeichnungsebene nach oben weisenden Fläche ganzflächig metallisiert. Die Metallisierung erstreckt sich auch über die Schnittkanten 29 und 30 sowie, was in der Zeichnung nicht erkennbar ist, über den Randbereich der nicht ganzflächig metallisierten Seite der Seitenwand 1. Diese Metallisierungen sind sämtlich miteinander leitend verbunden. Zur Herstellung der leitenden Verbindung zwischen den Befestigungswinkel 27 und dem Seitenteil 1 wird das Seitenteil 1 mit seinem in der Zeichnung nicht erkennbar metallisierten Randbereich gegen das Massefederband 28 angepreßt.

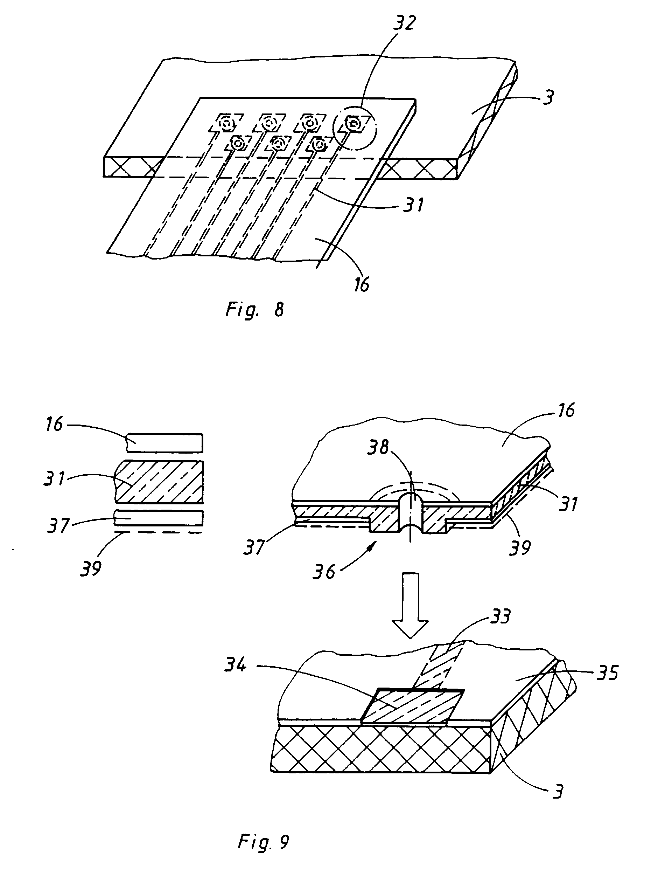

In den Fig. 8 und 9 sind ein flexibler Verbindungsstreifen 16 mit den darauf befindlichen Leiterbahnen 31 und deren elektrisch leitende Verbindung mit in der Zeichnung nicht dargestellten Leiterbahnen auf der Bodenplatte 3 gezeigt. Anstelle der Bodenplatte 3 kann es sich auch um eine der Seitenwände 1, 2 oder um eine sonstige Leiterplatte, wie beispielsweise 10 oder 11, handeln. Im einzelnen ist eine in ihrer Gesamtheit mit 32 bezeichnete Verbindung anhand von Fig. 9 dargestellt. Die starre Bodenplatte 3 besteht aus nichtleitendem glasfaserverstärktem oder kohlenfaserverstärktem Kunststoff. Sie kann auch aus einem nichtleitenden keramischen Material bestehen. Bei dem flexiblen Verbindungsstreifen 16 der auch "Flex" genannt wird, kann es sich um eine aus einem thermostabilen Polyimid bestehende Folie handeln, beispielsweise um Kapton der Fa. Du Pont. Die Leiterbahnen 31 befinden sich in der zeichnerischen Darstellung der Fig. 8 auf der Unterseite des flexiblen Streifens 16. Die auf der starren Leiterplatte 3 befindlichen Leiterbahnen sind in Fig. 8 nicht dargestellt. Die einzelnen in ihrer jeweiligen Gesamtheit mit 32 bezeichneten Verbindungen werden im folgenden anhand von Fig. 9 näher beschrieben.

im unteren Teil der Fig. 9 befindet sich auf der ausschnittsweise dargestellten starren Leiterplatte 3 eine Leiterbahn 33, an die sich elektrisch mit ihr verbunden eine Lötplatte 34 anschließt. Die Leiterbahn 33 und die Lötplatte 34 sind in bekannterweise, z. B. durch Ätzen, hergestellt und können, wenn gewünscht, unterschiedliche Stärken haben. Zumindest die Lötfläche 34 ist verzinnt oder mit einer aus der SMD-Technik bekannten Lötpaste beschichtet.

Auf der oberen Fläche der starren Leiterplatte 3 befindet sich eine den Lotfluß behindernde Deckfolie 35. Die Deckfolie 35 ist so geformt, daß sie die Lötfläche 6 von oben frei zugänglich läßt während sie die Leiterbahn 33 abdecken kann. Anstelle der Deckfolie 35 kann auch eine entsprechend ausgebildete. Beschichtung aus einem Lötstopplack verwendet werden. Die Oberfläche der Lötfläche 34 liegt geringfügig tiefer als die Oberfläche der den Lotfluß verhindernden Deckfolie 35.

Im oberen Teil der Fig. 9 befindet sich unter der als flexible Leiterplatte dienenden Folie 16 eine aus Kupfer bestehende Leiterbahn 31, die schmaler ausgebildet sein kann als in der Zeichnung dargestellt. Unterhalb der Leiterbahn 31 befindet sich mit dieser verbunden eine Lötfläche 36. Die Lötfläche 36 besitzt eine hohlzylindrische Gestalt und weist eine größere Höhe bzw. Stärke auf als die Leiterbahn 31. Ihre zur Lötfläche 34 weisende untere Kreisringfläche ist verzinnt oder mit einer zinnhaltigen Lötpaste beschichtet. Der Außendurchmesser der Kreisringfläche ist kleiner als die Seitenlänge der quadratischen Lötfläche 34 bzw. des in der Deckfolie 35 gebildeten Ausschnittes. Auf der Unterseite der Leiterbahn 31 befindet sich eine den Lötfluß verhindernde Deckfolie 37, die jedoch die zur Lötfläche 34 gerichtete kreisringförmige Lötfläche 36 nicht abdeckt. Anstelle der den Lötfluß verhindernden Deckfolie kann auch eine Schicht aus Lötstopplack verwendet werden.

Durch die flexible Folie 16 und die Leiterbahn 31 hindurch verläuft im Bereich der Lötfläche 36 und durch diese hindurch eine Kontrollbohrung 38. Die Unterseite der den Lötfluß verhindernden Deckfolie 37 ist mit einem wärmehärtbaren Kunststoffkleber beschichtet.

Zum Zusammenfügen der Verbindung werden die Leiterplatten 3 und 16 passgerecht aufeinander gedrückt und auf beiden Seiten, zumindest aber auf der Außenseite der Leiterplatte 16, erwärmt. Das Erwärmen kann beispielsweise mit einer entsprechend großen ebenen Fläche eines lötkolbenähnlichen Instrumentes erfolgen. Hierdurch schmilzt das auf den Lötflächen 34 und 36 befindliche Zinn und verbindet die Lötflächen miteinander. Zugleich härtet die Klebstoffschicht 39 aus und stellt eine zuverläßige mechanische Verbindung zwischen den Leiterplatten 3 und 16 her. Die Qualität der Lötverbindungen kann optisch durch die Kontrollbohrungen 38 hindurch kontrolliert werden.

Durch die oben beschriebene Verbindung bleibt eine, auf der den Verbindungen gegenüberliegenden Seite, der Leiterplatte 3 befindliche Metallisierung oder metallische Kaschierung völlig unberührt und unbeeinflußt.

## Patentansprüche

1. Geräteaufbau eines elektrotechnischen Gerätes mit plattenförmigen Gehäusewänden aus Kunststoff,
(a) die einseitig flächig metallisiert sind und
(b) die als Leiterplatten derart ausgebildet sind, daß sie auf der nicht flächig metallisierten Seite mit elektrischen und/oder mechanischen Bauteilen bestückt und mit Leiterbahnen versehen sind, die zur elektrischen Verbindung und/oder Anschluß von Bauteilen dienen
**dadurch gekennzeichnet, daß**
(c) die Gehäusewände aus miteinander mechanisch verbundenen plattenförmigen Bauteilen bestehen
(d) die metallisierten Flächen der Gehäusewände untereinander elektrisch verbunden sind und
(e) etwa vorhandene aus Metall bestehende weitere plattenförmige Bauteile (4,5,6,8,9) mit den metallisierten Flächen der Kunststoffplatten (1,2,3) elektrisch leitend verbunden sind.

2. Geräteaufbau nach Anspruch 1 **dadurch gekennzeichnet, daß** die Kunststoffplatten (1,2,3) einseitig ganzflächig metallisiert sind.

3. Geräteaufbau nach Anspruch 1 oder 2 **dadurch gekennzeichnet, daß** die Schnittkanten (29,30) der metallisierten Kunststoffplatten (1,2,3) metallisiert und mit den metallisierten Flächen elektrisch leitend verbunden sind.

4. Geräteaufbau nach einem oder mehreren der Ansprüche 1 bis 3 **gekennzeichnet durch** die Verwendung von Kartensteckern (20,21) zur Verbindung von Leiterplatten (3) mit weiteren innerhalb des Gehäuses angeordneten Leiterplatten (18) .

5. Geräteaufbau nach einem oder mehreren der Ansprüche 1 bis 4 **dadurch gekennzeichnet, daß** die Bestückung unter Anwendung der SMD-Technik erfolgt ist.

6. Geräteaufbau nach einem oder mehreren der Ansprüche 1 bis 5 **dadurch gekennzeichnet, daß** an Leiterplatten (1,2,3,10,11) auf biegsamen Folien (16) angeordnete Leiterbahnen (31) angeschlossen sind.

7. Geräteaufbau nach Anspruch 6 **dadurch gekennzeichnet, daß**
(a) auf der Oberfläche einer als Träger dienenden starren Leiterplatte (1,2,3,10,11) angeordnete Leiterbahnen (33) und
(b) auf der Oberfläche einer als Träger dienenden biegsamen Folie (16) angeordnete Leiterbahnen (31)
(c) durch Löten in der Weise miteinander verbunden sind, daß
(d) die Leiterbahnen (31,33) im Bereich der herzustellenden Verbindungen (32) Lötflächen (34,36) aufweisen.

8. Geräteaufbau nach Anspruch 7 **dadurch gekennzeichnet, daß** die Lötflächen (34,36) auf mindestens einem der Träger (3,16) zumindest teilweise durch eine den Lötfluß behindernde Deckfolie (35,37) oder eine Schicht von Lötstopplack umgeben sind.

9. Geräteaufbau nach Anspruch 7 oder 8 **dadurch gekennzeichnet, daß** auf einem Träger (3) die Oberflächen der Lötflächen (34) bzw. ihrer Beschichtungen gegenüber der Oberfläche der Deckfolie (35) bzw. des Lötstopplackes vertieft angeordnet sind.

10. Geräteaufbau nach einem oder mehreren der Ansprüche 7 bis 9 **dadurch gekennzeichnet, daß** auf dem anderen Träger (16) die Oberflächen der Lötflächen (36) gegenüber der Oberfläche der Deckfolie (37) bzw. des Lötstopplackes erhöht angeordnet sind.

11. Geräteaufbau nach einem oder mehreren der Ansprüche 7 bis 10 **dadurch gekennzeichnet, daß** die Lötflächen (34) auf mindestens einem Träger (3) rechteckig oder quadratisch sind.

12. Geräteaufbau nach einem oder mehreren der Ansprüche 7 bis 11 **dadurch gekennzeichnet, daß** die Lötflächen (36) auf einem Träger (16) kreisförmig oder kreisringförmig sind.

13. Geräteaufbau nach einem oder mehreren der Ansprüche 7 bis 12 **dadurch gekennzeichnet, daß** die parallel zu den Trägern verlaufenden Abmessungen der Lötflächen (36) des einen Trägers (16) kleiner sind als die der korrespondierenden Lötflächen (34) des anderen Trägers (3).

14. Geräteaufbau nach einem oder mehreren der Ansprüche 7 bis 13 **dadurch gekennzeichnet, daß** in den Lötflächen (36) eines Trägers (16) Kontrollöffnungen (38) angeordnet sind.

15. Geräteaufbau nach Anspruch 14 **dadurch gekennzeichnet, daß** die Kontrollöffnungen (38) Bohrungen sind, die im wesentlichen senkrecht zu den Lötflächen (36) verlaufen.

16. Geräteaufbau nach Anspruch 15 **dadurch gekennzeichnet, daß** die Bohrungen (38) sich durch den Träger (16) hindurch erstrecken.

17. Geräteaufbau nach einem oder mehreren der Ansprüche 7 bis 16 **dadurch gekennzeichnet, daß** die mechanische Verbindung zwischen den Trägern (3, 16) durch eine Klebstoffschicht (39) erfolgt, die die zu verlötenden Bereiche frei läßt.

18. Geräteaufbau nach Anspruch 17 **dadurch gekennzeichnet, daß** die Klebstoffschicht (39) aus einem wärmehärtbaren Kunststoff besteht.

19. Geräteaufbau nach einem oder mehreren der Ansprüche 1 bis 18 **dadurch gekennzeichnet, daß** die plattenförmigen Bauteile (1,2,3,10,11) aus mit Glasfasern und/oder Kohlefasern verstärkten Kunststoffen bestehen.

20. Geräteaufbau nach einem oder mehreren der Ansprüche 1 bis 19 **dadurch gekennzeichnet, daß** außenseitig metallischer oder metallisierter plattenförmiger Bauteile Leiterplatten (10,11) angeordnet sind, die Gerätestecker (14), Teststecker (15) und/oder weniger schutzbedürftige Bauteile tragen.

21. Geräteaufbau nach einem oder mehreren der Ansprüche 1 bis 20 **dadurch gekennzeichnet, daß** die einseitig vollständig metallisierten plattenförmigen Bauteile (1,2,3) auf der der ganzflächigen Metallisierung gegenüberliegenden Seite im Randbereich mit Metallisierung versehen sind, die mit der ganzseitigen Metallisierung in elektrisch leitender Verbindung steht.

## Claims

1. Device construction of an electro-technical device having plate-shaped housing walls of synthetic material,
(a) which are metallized at the surface of one side and
(b) which are formed as printed circuit boards in such a way, that they are provided with electrical and/or mechanical components on the not-metallized side and with strip connectors, which serve for electrical connection of components,
**characterized in that**
(c) the housing walls consist of plate-shaped components, which are interconnected mechanically,
(d) the metallized surfaces of the housing walls are electrically interconnected, and
(e) further plate-shaped components (4,5,6,8,9) of metal, if present, are electrically connected to the metallized surfaces of the synthetic material plates (1,2,3).

2. Device construction as set forth in claim 1, **characterized in that** the synthetic material plates (1,2,3) are metallized on one side over their total surfaces.

3. Device construction as set forth in claim 1 or 2, **characterized in that** the intersection edges (29,39) of the metallized synthetic material plates (1,2,3) are metallized and electically connected to the metallized surfaces.

4. Device construction as set forth anyone of the claims 1 to 3, **characterized by** the use of board connectors (20,21) for connecting printed circuit boards (3) to further printed circuit boards (18) arranged within the housing.

5. Device construction as set forth in anyone of the claims 1 to 4, **characterized in that** the assembly is effected by use of the SMD-technique.

6. Device construction as set forth in anyone of the claims 1 to 5, **characterized in that** strip conductors arranged on flexible foils (16) are provided at printed circuit boards (1,2,3,10,11).

7. Device construction as set forth in claim 6, **characterized in that**
(a) strip conductors (33) arranged at the surface of a rigid printed circuit boards (1,2,3,10,11) serving as carrier and
(b) strip conductors (31) arranged at the surface of a flexible foil (16) serving as carrier
(c) are interconnected by soldering in such a way, that (d) the strip conductors (31,33) have soldering surfaces (34,36) in the area of the connections (32) to be provided.

8. Device construction as set forth in claim 7, **characterized in that** the soldering surfaces (34,36) provided at at least one of the carrier (3,16) are at least partly surrounded by a cover foil (35,37) or a layer of soldering stop lacquer.

9. Device construction as set forth in claim 7 or 8, **characterized in that,** on one carrier (3), the surfaces of the soldering surfaces (34) and of their coatings, respectively, are arranged in recesses relatively to the surface of the cover foil (35) and the soldering stop lacquer, respectively.

10. Device construction as set forth in anyone of the claims 7 to 9, **characterized in that,** on the other carrier (16), the surfaces of the soldering surfaces (36) are arranged on raised areas relatively to the surface of the cover foil (37) and the soldering stop lacquer, respectively.

11. Device construction as set forth in anyone of the claims 7 to 10, **characterized in that** the soldering surfaces (34) are rectangular or square at at least one carrier (3).

12. Device construction as set forth in anyone of the claims 7 to 11, **characterized in that** the soldering surfaces (36) are circular or annular at one carrier (16).

13. Device construction as set forth in anyone of the claims 7 to 12, **characterized in that** the dimensions of the soldering surfaces (36) of one of the carriers (16) extending parallel to the carriers are smaller than those of the corresponding soldering surfaces (34) of the other carrier (3).

14. Device construction as set forth in anyone of the claims 7 to 13, **characterized in that** inspection openings (38) are provided in the soldering surfaces (36) of a carrier (16).

15. Device construction as set forth claim 14, **characterized in that** the inspection openings (38) are bores, which extend substantially perpendicular to the soldering surfaces (36).

16. Device construction as set forth in claim 14, **characterized in that** the bores (38) extend through the carrier (16).

17. Device construction as set forth in anyone of the claims 7 to 16, **characterized in that** the mechanical connection between the carriers (3,16) is effected by an adhesive layer (39), which leaves free the areas to be soldered.

18. Device construction as set forth claim 17, **characterized in that** the adhesive layer (39) consists of a heat hardenable synthetic material.

19. Device construction as set forth in anyone of the claims 1 to 18, **characterized in that** the plate-shaped components (1,2,3,10,11) consist of synthetic material reinforced by glass fibres and/or carbon fibres.

20. Device construction as set forth in anyone of the claims 1 to 19, **characterized in that** printed circuit boards (10,11), which carry device connectors (14), test connectors (15) and/or components with less need of protection, are arranged at the outside of metallic or metallized plate-shaped components.

21. Device construction as set forth in anyone of the claims 1 to 20, **characterized in that** the plate-shaped components (1,2,3) completely metallized on one side are provided with metallization areas in the edge area on the side remote from the total-surface metallization, which metallization areas are electrically connected to the total-surface metallization.

## Revendications

1. Construction d'ensemble d'un appareil électrotechnique muni de parois de boîtier en forme de plaques composées de matière synthétique,
(a) qui sont métallisées uniformément sur un côté et
(b) qui sont développées en plaquettes de circuits imprimés de telle façon qu'elles sont équipées de composants électriques et/ou mécaniques sur le côté non-métallisé uniformément ou pourvues de pistes conductibles servant à connecter et/ou à raccorder électriquement des composants,
**caractérisée par le fait que**
(c) les parois de boîtier se composent de composants en forme de plaques connectés mécaniquement les uns aux autres
(d) les surfaces métallisées des parois de boîtier sont connectées entre elles électriquement et
(e) d'autres composants possibles en métal en forme de plaques (4,5,6,8,9) sont connectés aux surfaces métallisées des plaques en matière synthétique (1,2,3) de façon à conduire le courant électrique.

2. Construction d'ensemble selon la revendication 1, **caractérisée par le fait que** les plaques en matière synthétique (1,2,3) sont métallisées d'un côté complètement uniformément.

3. Construction d'ensemble selon la revendication 1 ou 2, **caractérisée par le fait que** les arêtes de coupe (29,30) des plaques en matière synthétique (1,2,3) métallisées sont métallisées et connectées aux surfaces métallisées de façon à conduire le courant électrique.

4. Construction d'ensemble selon l'une ou plusieurs des revendications 1 à 3, **caractérisée par** l'utilisation de connecteurs de cartes (20,21) destinés à connecter des plaquettes de circuits imprimés (3) à d'autres plaquettes de circuits imprimés (18) disposées à l'intérieur du boîtier.

5. Construction d'ensemble selon l'une ou plusieurs des revendications 1 à 4, **caractérisée par le fait que** l'équipement a lieu en appliquant la technique du montage en surface.

6. Construction d'ensemble selon l'une ou plusieurs des revendications 1 à 5, **caractérisée par le fait que** des pistes conductibles (31) disposées sur des feuilles souples (16) sont raccordées à des plaquettes de circuits imprimés (1,2,3,10,11).

7. Construction d'ensemble selon la revendication 6, **caractérisée par le fait que**
(a) des pistes conductibles (33) disposées à la surface d'une plaquette rigide de circuits imprimés (1,2,3,10,11) servant de support et
(b) des pistes conductibles (31) disposées à la surface d'une feuille souple (16) servant de support
(c) sont connectées les unes aux autres par brasage de telle façon que
(d) les pistes conductibles (31,33) présentent des surfaces de brasage (34,36) dans le domaine des connexions devant être établies (32).

8. Construction d'ensemble selon la revendication 7, **caractérisée par le fait que** les surfaces de brasage (34,36) sont entourées sur au moins l'un des supports (3,16) du moins en partie par une feuille de recouvrement (35,37) empêchant le flux de brasage ou par une couche de réserve de brasage.

9. Construction d'ensemble selon la revendication 7 ou 8, **caractérisée par le fait que,** sur un support (3), les surfaces des surfaces de brasage (34) et de leurs recouvrements respectivement sont disposées en profondeur par rapport à la surface de la feuille de recouvrement (35) et de la réserve de brasage respectivement.

10. Construction d'ensemble selon l'une ou plusieurs des revendications 7 à 9, **caractérisée par le fait que,** sur l'autre support (16), les surfaces des surfaces de brasage (36) sont disposées en hauteur par rapport à la surface de la feuille de recouvrement (37) et de la réserve de brasage respectivement.

11. Construction d'ensemble selon l'une ou plusieurs des revendications 7 à 10, **caractérisée par le fait que** les surfaces de brasage (34) sont carrées ou rectangulaires sur au moins un support (3).

12. Construction d'ensemble selon l'une ou plusieurs des revendications 7 à 11, **caractérisée par le fait que** les surfaces de brasage (36) sont en forme d'anneau ou en forme d'anneau de cercle sur un support (16).

13. Construction d'ensemble selon l'une ou plusieurs des revendications 7 à 12, **caractérisée par le fait que** les dimensions des surfaces de brasage (36) d'un support (16) s'étendant parallèlement aux supports sont inférieures à celles des surfaces de brasage (34) correspondantes de l'autre support (3).

14. Construction d'ensemble selon l'une ou plusieurs des revendications 7 à 13, **caractérisée par le fait que** des ouvertures de contrôle (38) sont disposées dans les surfaces de brasage (36) d'un support (16).

15. Construction d'ensemble selon la revendication 14, **caractérisée par le fait que** les ouvertures de contrôle (38) sont des perçages qui s'étendent essentiellement verticalement par rapport aux surfaces de brasage (36).

16. Construction d'ensemble selon la revendication 15, **caractérisée par le fait que** les perçages (38) s'étirent à travers le support (16).

17. Construction d'ensemble selon l'une ou plusieurs des revendications 7 à 16, **caractérisée par le fait que** la connexion mécanique entre les supports (3,16) a lieu par une couche de colle (39) qui libère les domaines devant être fermés par brasage.

18. Construction d'ensemble selon la revendication 17, **caractérisée par le fait que** la couche de colle (39) se compose d'une matière synthétique susceptible de durcir à la chaleur.

19. Construction d'ensemble selon l'une ou plusieurs des revendications 1 à 18, caractérisée par le fait que les composants en forme de plaques (1,2,3,10,11) se composent de matières synthétiques renforcées à la fibre de verre et/ou à la fibre de carbone.

20. Construction d'ensemble selon l'une ou plusieurs des revendications 1 à 19, **caractérisée par le fait que** des plaquettes de circuits imprimés (10,11) portant des socles connecteurs (14), des connecteurs test (15) et/ou des composants ayant moins besoin d'être protégés sont disposées sur le côté extérieur des composants en forme de plaques métallisés ou métalliques.

21. Construction d'ensemble selon l'une ou plusieurs des revendications 1 à 20, **caractérisée par le fait que** les composants (1,2,3) en forme de plaques complètement métallisés sur un côté sont pourvus, dans le domaine marginal sur le côté opposé à la métallisation complètement uniforme, d'une métallisation connectée de façon à conduire le courant électrique à la métallisation située sur le côté entier.
